Europäisches Patentamt

European Patent Office

Office européen des brevets

(19)

(11) Publication number: **0 401 765**
**A2**

## (12) EUROPEAN PATENT APPLICATION

(21) Application number: **90110639.3**

(22) Date of filing: **05.06.90**

(51) Int. Cl.5: **H01L 39/12, C04B 35/00**

(30) Priority: **05.06.89 JP 141004/89**

(43) Date of publication of application:
**12.12.90 Bulletin 90/50**

(84) Designated Contracting States:
**DE FR GB NL**

(71) Applicant: **NEC CORPORATION**
**7-1, Shiba 5-chome Minato-ku**
**Tokyo 108-01(JP)**

(72) Inventor: **Shimakawa, Yuichi, c/o NEC**
**Corporation**
**7-1 Shiba 5-chome**
**Minato-ku, Tokyo(JP)**
Inventor: **Kubo, Yoshimi, c/o NEC Corporation**
**7-1 Shiba 5-chome**
**Minato-ku, Tokyo(JP)**
Inventor: **Manako, Takashi, c/o NEC**
**Corporation**
**7-1 Shiba 5-chome**
**Minato-ku, Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) **An oxide superconductor composition and a process for the production thereof.**

(57) An oxide superconductor composition represented by a formula:
$$Tl_2(Ba_{1-x}La_x)_2CuO_y \quad (I)$$
wherein $0.0 < x < 0.2$ is provided. This composition has a high superconducting transition temperature (Tc) and a high critical current density (Jc). This composition can be produced by sintering a pressure-molded mixture of thallium oxide ($Tl_2O_3$), barium oxide (BaO), lanthanum oxide ($La_2O_3$) and cupric oxide (CuO) in an atomic ratio Tl:Ba:La:Cu of 2:2(1-x):2x:1.

EP 0 401 765 A2

## An oxide superconductor composition and a process for the production thereof

## BACKGROUND OF THE INVENTION

### Field of the invention

The present invention relates to an oxide superconductor composition for use in various superconductivity application apparatus and superconducting devices, and a process for the production thereof.

### Description of the prior art

Up to the present, metal or alloy superconducting materials, intermetallic compound superconducting materials, etc. have already been put into practical use as superconducting materials. The superconducting materials are used for production of coils for superconducting magnets, electronics devices such as Josephson devices, etc. and are expected to realize applications particularly to Superconducting Quantum Interference Devices ($=$SQUID) and precision measurement techniques, utilizing the merits of high sensitivity, high precision and low noise properties of a Josephson junction, and also to electronic computers, taking advantage of high speed responsibility and low electric power consumption properties of the Josephson junction.

It is desired that a superconducting transition temperature (Tc) of a material is as high as possible. Since an oxide superconductor in the La-Ba-Cu-O system having a Tc around 30K was found, there are successively found oxide superconductors of Ba-Y-Cu-O system having a Tc around 90K, Bi-Sr-Ca-Cu-O system having a Tc around 110K, Tl-Ba-Ca-Cu-O system having a Tc around 120K, etc. These findings of the materials having high Tc and being easily producible are further enhancing expectations for use as practical materials.

For applying a superconducting material to an electronics device, it is preferred that its Tc is as high as possible. It is also important that the critical current density (Jc) is as large as possible, from the viewpoint of wiring materials.

Prior art Tl system oxide superconductor compositions represented by $Tl_2Ba_2CuO_y$, when they are sintered in accordance with a conventional ceramics production process, does not show superconductivity at all or show superconductivity only at a very low temperature below 10K.

## SUMMARY OF THE INVENTION

An object of the present invention is therefore to present an oxide superconductor composition which has a Tc higher than that of the prior art superconductor and at the same time has a high Jc, even if it is sintered by an ordinary ceramics production process, and a process for the production thereof.

The present inventors have found through intensive and extensive researches that an oxide superconductor composition essentially consisting of thallium (Tl) barium (Ba) lanthanum (La) copper (Cu) oxide wherein atomic ratio of thallium:barium:lanthanum:copper is expressed by 2:2(1-x):2x:1, where $0.0 < x < 0.2$, and more particularly represented by a general formula:

$$Tl_2(Ba_{1-x}La_x)_2CuO_y \quad (I)$$

wherein $0.0 < x < 0.2$

has a high Tc and a high Jc, and can be produced by mixing powders of $Tl_2O_3$ BaO, $La_2O_3$ and CuO, pressure molding the mixture and sintering the mixture in a temperature range of 870-910° C.

In the composition of the above formula (I), x should not exceed 0.2, since such x higher than 0.2 would cause increase of impurity phase and thus lowering of Jc and so would not be suitable for practical use. There is no special limitation to a range of y, which however is ordinarily 5.5 - 6.5.

## DESCRIPTION OF THE PREFERRED EMBODIMENTS

2

The present invention will be explained below further in detail with respect to its some embodiments shown as working examples.

As for starting materials, thallium oxide ($Tl_2O_3$), barium oxide (BaO), lanthanum oxide ($La_2O_3$) and cupric oxide (CuO), respectively of 99% or more purity were used. These materials were respectively weighed to take up them in the composition ratio shown in the undermentioned table 1, well mixed in a mortar and then pressed into a pressed body in a size of 5mm x 10mm x 1mm. This pressed body was wrapped with gold foil and sintered at 870 - 910°C for 1 - 10 hours in an oxygen atmosphere.

Then measurements were made on the samples obtained as to their resistivities, critical current densities, and superconducting volume fractions in order to evaluate their superconducting properties.

The resistivity was measured by using a dc four probe method. The electrical contacts were made by using gold electrodes sputtered on the sample surface and the copper lead wires plated with tin.

The critical current density also was measured by the dc four probe method. The current value at which 0.1 $\mu$V or more voltage was generated between the voltage leads at the liquid helium temperature of 4.2K was employed as Jc.

The superconducting volume fraction was obtained by an ac magnetic susceptibility measurement, which was carried out by determining any change of inductance L of a coil wherein a sample was placed, and calculating on the basis of $\Delta$ L at 4.2K of lead of the same volume and the same shape as equal to 100.

The resistivity measurement was made within a temperature range of from a room temperature to a temperature showing zero resistivity and the magnetic susceptibility measurement was made within a temperature range of from a room temperature to 4.2K.

In the following table 1, the composition ratio [value of x in the formula $Tl_2(Ba_{1-x}La_x)_2CuO_y$], the superconducting transition temperature Tc, the critical current density Jc at 4.2K and the superconducting volume fraction as measured on the samples are shown:

Table 1

| Sample No. | Composition (x value) | Tc (K) | Jc ($A/cm^2$) | Volume fraction (%) |
|---|---|---|---|---|
| 1 | 0.05 | 25 | 750 | 70 |
| 2 | 0.1 | 40 | 1,000 | 80 |
| 3 | 0.15 | 45 | 1,100 | 85 |

In contrast to the above, a composition of $Tl_2Ba_2CuO_y$ produced in the similar manner and sintered at 890°C did not show superconductivity at a temperature not lower than the liquid helium temperature of 4.2K. On the other hand, the composition of the present invention for example of $Tl_2(Ba_{0.9}La_{0.1})_2CuO_y$ showed superconductivity at 40K and critical current density Jc of 1,000 $A/cm^2$ at 4.2K as shown in the above table 1.

Separately in the above example, the pressed body was sintered without wrapping by gold foil. In this case, the volume fraction was lowered owing to change of composition ratio caused by lost of Tl in sintering.

Thus the present invention provides a very useful superconductor composition having a high superconducting transition temperature Tc.

**Claims**

1. A superconductor composition essentially consisting of thallium (Tl) barium (Ba) lanthanum (La) copper (Cu) oxide wherein atomic ratio of thallium:barium:lanthanum: copper is expressed by 2:2(1-x):2x:1, where 0.0 < x < 0.2.

2. The superconductor composition according to claim 1 wherein it has a composition represented by the general formula:

$Tl_2(Ba_{1-x}La_x)_2CuO_y$     (I)

wherein 0.0 < x < 0.2.

3. A process for the production of an oxide superconductor composition comprising thallium (Tl), barium (Ba) lanthanum (La) and copper (Cu) in a form of an oxide; an atomic ratio of which elements is expressed by 2:2(1-x):2x:1, wherein powders of thallium oxide (Tl$_2$O$_3$), barium oxide (BaO), lanthanum oxide (La$_2$O$_3$) and cupric oxide (CuO) are mixed together in an equivalent ratio corresponding to the above atomic ratio, pressure molded and sintered in a temperature range of 870-910°C.

4. The process according to claim 3, wherein said powders as mixed and pressure molded are wrapped with a gold foil and then sintered.